# EUROPEAN PATENT SPECIFICATION

(11) **EP 4 303 934 B1**
(45) Date of publication and mention of the grant of the patent: **28.10.2026**
(21) Application number: 23163850.3
(22) Date of filing: 23.03.2023
(51) Int. Cl.: H02M 3/00, H10D 30/01, H10D 30/60, H10D 62/10, H10D 62/17, H10D 84/01, H10D 84/03, H10D 84/85, H10D 89/10, H02M 3/156

(54) **POWER MANAGEMENT INTEGRATED CIRCUIT AND SEMICONDUCTOR PACKAGE INCLUDING THE SAME**
INTEGRIERTE LEISTUNGSVERWALTUNGSSCHALTUNG UND HALBLEITERGEHÄUSE DAMIT
CIRCUIT INTÉGRÉ DE GESTION D'ÉNERGIE ET BOÎTIER DE SEMI-CONDUCTEUR LE COMPRENANT

(30) Priority: 08.07.2022 KR 20220084223; 24.08.2022 KR 20220106120
(43) Date of publication of application: 10.01.2024
(73) Proprietor: Samsung Electronics Co., Ltd., Suwon-si, Gyeonggi-do 16677 (KR)
(72) Inventor: OH, Jung-Hyun, 16677 Suwon-si (KR); KIM, Jungkyung, 16677 Suwon-si (KR); PARK, Yeonghun, 16677 Suwon-si (KR); CHANG, Hoon, 16677 Suwon-si (KR)
(74) Representative: Marks & Clerk LLP

(56) References cited:
- US-A1- 2011 068 406

## Description

### BACKGROUND

The present disclosure relates to a power management integrated circuit and a semiconductor package, and more particularly, to a power management integrated circuit with increased endurance.

A power management integrated circuit (PMIC) has recently emerged as an important issue due to an increase in need for effective power management of mobile products such as smart phones or tablet personal computers (PCs). In particular, a decrease in power consumption and an increase in efficiency are essential aspects of power management integrated circuits in mobile devices. Switching regulators, such as pulse width modulation direct current-to-direct current (PWM DC-DC) converters, capable of providing power with high driving voltage and excellent power efficiency have been widely used in power management integrated circuits.

United States Patent Application Publication number US 2011/068406 A1 relates to a semiconductor device includes a semiconductor layer of a first conductivity type, a first source portion, a second source portion, a drain portion, a first main electrode, a second main electrode, and a gate electrode. The first source portion includes a first source contact region of a second conductivity type and a back gate contact region of the first conductivity type. The drain portion includes a drain contact region of the second conductivity type, a first drift region of the second conductivity type, and a second drift region of the second conductivity type. When a reverse bias is applied to p-n junction between the semiconductor layer and the drain portion, avalanche breakdown is more likely to occur near the first drift region than near the second drift region.

### SUMMARY

It is an aspect to provide a power management integrated circuit that prevents a drop in snapback breakdown voltage and prevents an increase in specific on-resistance.

It is another aspect to provide a semiconductor package using a power management integrated circuit.

In order to solve the above problem, a power management integrated circuit according to one of claim 1 and claim 2 is provided.

Preferred embodiments are set out in the dependent claims.

### BRIEF DESCRIPTION OF THE DRAWINGS

FIG. 1 illustrates a block diagram showing an electronic device including a power management integrated circuit according to some embodiments.
FIG. 2 illustrates a block diagram showing a power management integrated circuit according to some embodiments.
FIG. 3 illustrates a circuit diagram showing a DC-DC converter according to some embodiments.
FIG. 4 illustrates a plan view showing a semiconductor device according to some embodiments.
FIGS. 5A and 5B illustrate cross-sectional views respectively taken along lines A-A' and B-B' of FIG. 4.
FIG. 6 illustrates a plan view showing a semiconductor device according to a comparative example.
FIG. 7 illustrates a cross-sectional view taken along line A-A' of FIG. 6.
FIG. 8 illustrates a plan view showing a power management integrated circuit chip according to some embodiments.
FIG. 9 illustrates a plan view of one DC-DC converter in a buck converter region of the power management integrated circuit chip shown in FIG. 8, according to some embodiments.
FIG. 10 illustrates an enlarged plan view showing one transistor set of the DC-DC converter of FIG. 9 according to some embodiments.
FIGS. 11A, 11B, and 11C illustrate cross-sectional views respectively taken along lines A-A', B-B', and C-C' of FIG. 10.
FIGS. 12 to 15 illustrate enlarged plan views showing one transistor set of the DC-DC converter of FIG. 9 according to some embodiments.
FIGS. 16 and 17 illustrate cross-sectional views showing a semiconductor package including a power management integrated circuit according to some embodiments.

### DETAILED DESCRIPTION

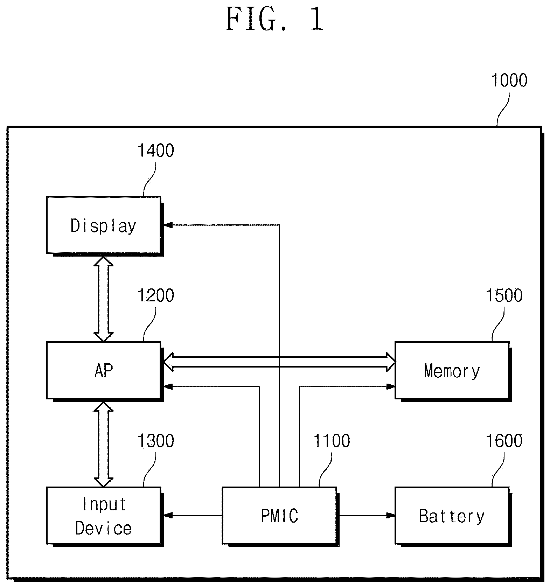

FIG. 1 illustrates a block diagram showing an electronic device including a power management integrated circuit according to some embodiments.

Referring to FIG. 1, an electronic device 1000 may include a power management integrated circuit (PMIC) 1100, an application processor (AP) 1200, an input device 1300, a display 1400, a memory 1500, and a battery 1600. For example, the electronic device 1000 may be one of apparatuses included in an automotive vehicle. In some embodiments, the electronic device 1000 may be one of a smart phone, a personal computer (PC), a tablet PC, a net-book computer, an e-reader, a personal digital assistant (PDA), a portable multimedia player (PMD), an MP3 player, an ultra-mobile PC (UMPC), a workstation, a portable computer, a web tablet PC, a tablet computer, a wireless phone, a mobile phone, an e-book, a portable game console, a navigation system, a black box, a digital camera, digital multimedia broadcasting (DMB) player, a three-dimensional television, a smart television, a digital audio recorder, a digital picture player, a digital video recorder, a digital video player, a storage included in a data center, a device capable of communicating information under wireless environment, one of various electronic devices included in a computer network, one of various electronic devices included in a telematics network, a radio frequency identification (RFID) device, or one of various components included in a computing system. In some embodiments, the electronic device 1000 may be a wearable device, such as an electronic bracelet or an electronic necklace.

The power management integrated circuit 1100 may receive power from the battery 1600. The power management integrated circuit 1100 may supply power to AP 1200, the input device 1300, the display 1400, and/or the memory 1500, and may manage the power in relation to the application processor 1200, the input device 1300, the display 1400, and/or the memory 1500. The electronic device 1000 may include at least one power management integrated circuit 1100. For example, the electronic device 1000 may use a single power management integrated circuit 1100 to supply power to the application processor 1200, the input device 1300, the display 1400 and/or the memory 1500. For another example, the electronic device 1000 may include a plurality of power management integrated circuits 1100 for individually supplying power to the application processor 1200, the input device 1300, the display 1400, and the memory 1500.

The application processor 1200 may control an overall operation of the electronic device 1000. For example, in response to an input signal generated from the input device 1300, the application processor 1200 may allow the display 1400 to display data stored in the memory 1500. The input device 1300 may be implemented as a keyboard, a keypad, or a pointing device such as a touch pad or a computer mouse.

The power management integrated circuit 1100 according to some embodiments may operate with an extended operating bandwidth and a relaxed phase margin by securing additional zero and pole. In addition, the power management integrated circuit 1100 according to some embodiments may operate with improved frequency response properties by adjusting zero and pole based on an operating frequency.

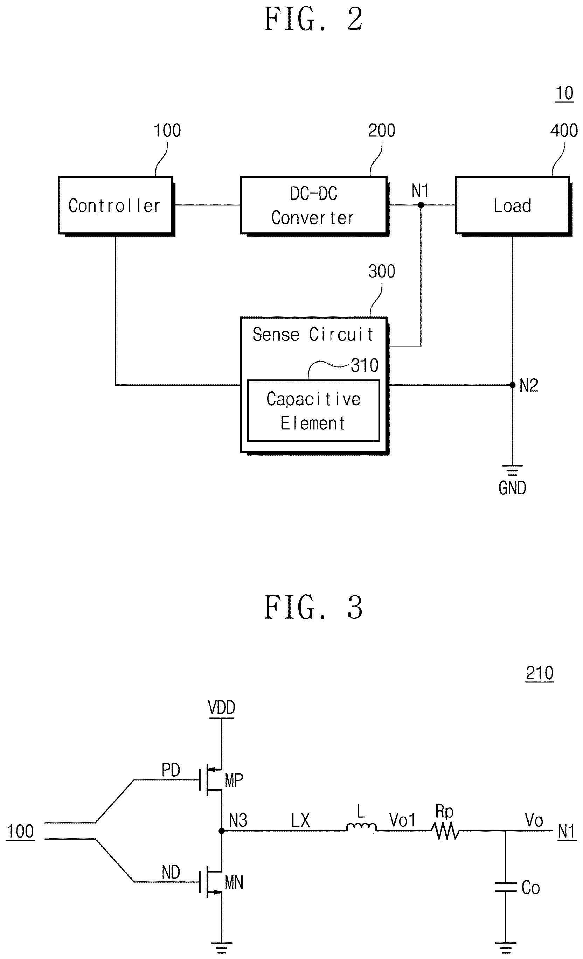

FIG. 2 illustrates a block diagram showing a power management integrated circuit according to some embodiments. A power management integrated circuit 10 of FIG. 2 may be understood as an example of the power management integrated circuit 1100 of FIG. 1.

Referring to FIG. 2, the power management integrated circuit 10 may supply power and/or clock signals for the electric apparatus (see 1000 of FIG. 1). The power management integrated circuit 10 may receive power externally, may convert and/or rectify the received power into a stable voltage or current, and may then distribute and control the voltage or current. The power management integrated circuit 10 may be implemented either as a single semiconductor chip or as a set of a plurality of semiconductor chips.

The power management integrated circuit 10 may include a controller 100, a DC-DC converter 200, a sense circuit 300, and a load 400. The sense circuit 300 may include a capacitive element 310.

The controller 300 may control the power management integrated circuit 10 and intelligent elements (e.g., the DC-DC converter 200 and the sense circuit 300) in the power management integrated circuit 10. For example, the controller 100 may output control signals that control the intelligent elements in the power management integrated circuit 10.

In an embodiment, the controller 100 may generate output power (e.g., voltage or current) provided to the load 400 by adjusting a switching time (or intermittence period) of the DC-DC converter 200. The controller 100 may be provided with a variation in output power that is provided through the sense circuit 300 to the load 400. In response to a fluctuation in output power, the controller 100 may adjust the switching time of the DC-DC converter 200.

The controller 100 may be implemented as a central processing unit (CPU), an arithmetic logic circuit (ALU) that performs an arithmetic logic operation or a bit shifting, a digital signal processor (DSP), a microprocessor, an application specific integrated circuit (ASIC), or a control logic, but embodiments are not limited thereto. In some embodiments, the controller 100 may include a state machine constituted by a plurality of logic gates, or a combination of processor and memory that stores instructions executable by the processor.

The DC-DC converter 200 converts a direct current (DC) having a certain level into DC power having another level. In an embodiment, the DC-DC converter 200 may use a switching element to intermit input DC power that is externally provided. The DC-DC converter 200 may adjust a switching period to generate output DC power. The input DC power externally provided may be supplied from the battery (see 1600 of FIG. 1). The output DC power may be provided to the load 400 included in the power management integrated circuit 10. The output DC power may be used as a source voltage of signal fluctuation that the sense circuit 300 is intended to detect.

A switching regulator may be used as one of various examples of the DC-DC converter 200. The switching regulator may generate DC power by adjusting a switching period of a switching element. For example, the switching regulator may use a ramp signal to generate a pulse width modulation (PWM) signal, and in response to the PWM signal, may raise or reduce an input voltage to generate an output voltage.

The DC-DC converter 200 includes a buck converter that generates power whose level is less than a level of an input power that is input to the DC-DC converter 200. Not covered by the claims are other converters like a boost converter that generates power whose level is greater than the level of the input power that is input to the DC-DC converter 200, and a buck-boost converter that generates power whose level is greater or less than the level of the input power to the DC-DC converter 200.

The sense circuit 300 may detect output power supplied to the load 400. According to some embodiments, the sense circuit 300 may monitor output power (e.g., output voltage, output power, output frequency, etc.) supplied through a first node N1 to the load 400, thereby providing the controller 100 with information about voltage drop or voltage rise associated with the output power. In response to a variation in voltage, the controller 100 or a system (e.g., the electronic device 1000 of FIG. 1) that includes the power management integrated circuit 10 may take action for a stable operation. This action may be implemented in the form of hardware or software. For measurement accuracy, the sense circuit 300 may be connected through a second node N2 to ground power GND. The ground power GND may be called ground.

The sense circuit 300 may monitor a state of output power within a preset operating bandwidth range. There may be a trend of increase in size and variation of output power (e.g., output current) that is output from the DC-DC converter 200. A sudden variation in output current may cause an output voltage to drop to a level less than a critical value, and the load 400 may not be provided with an output voltage having an appropriate level, which may result in malfunction. The DC-DC converter 200 may have a restriction in operating bandwidth because of structural characteristics and may experience switching loss, and thus there may be a limitation in raising an operating frequency.

According to some embodiments, the sense circuit 300 may include the capacitive element 310. The capacitive element 310 may be a device in which a phase of current is ahead of a phase of voltage in an alternating current circuit. In an embodiment, the capacitive element 310 may include at least one capacitor. The capacitive element 310 may include a variable capacitor. The capacitive element 310 may include a capacitor array made of one or more capacitors. Embodiments, however, are not limited thereto, and in some embodiments, the capacitive element 310 may be implemented in the form of a combination of various passive elements capable of changing capacitance.

According to some embodiments, the capacitive element 310 may be added to a negative feedback path of the sense circuit 300. Since the capacitive element 310 is added to the sense circuit 300, it may be possible to generate an additional zero and pole in relation to the sense circuit 300. The additional zero and pole may increase an operating bandwidth and a phase margin of the capacitive element 310.

According to some embodiments, a total capacitance of the capacitive element 310 may be adjusted. For example, the total capacitance of the capacitive element 310 may be previously determined in accordance with an allowable operating frequency or an allowable operating bandwidth of the power management integrated circuit 10. The total capacitance of the capacitive element 310 may be adjusted such that optimal pole and/or zero may be achieved in accordance with a requirement of the load 400 or control of a system (e.g., the electronic device 1000 of FIG. 1).

The load 400 may be a certain element that consumes electrical energy managed by the power management integrated circuit 10 or a system including the power management integrated circuit 10. For example, the load 400 may be a modeling of total resistance required for an operation of the electrical device 1000. The load 400 may be provided with current or voltage from the power management integrated circuit 10. In some embodiments, the load 400 is described as being included in the power management integrated circuit 10, but this is merely an example for convenience of description. The load 400 may be understood as a modeling of various systems or devices that require voltage and/or current for operating the electric device 1000.

Since the power management integrated circuit 10 includes the capacitive element 310 in the sense circuit 300, it may be possible to overcome a structural limitation of the DC-DC converter 200. According to some embodiments, because the power management integrated circuit 10 includes the capacitive element 310 in the sense circuit 300, it may be possible to expand an operating bandwidth and a phase margin and to stabilize a system including the power management integrated circuit 10.

FIG. 3 illustrates a circuit diagram showing a DC-DC converter according to some embodiments. A DC-DC converter 210 depicted in FIG. 3 may be an example embodiment of the DC-DC converter 200 shown in FIG. 2.

Referring to FIG. 3, the DC-DC converter 210 is a buck converter capable of generating output power having a level less than that of input power. The DC-DC converter 210 includes a P-type metal oxide semiconductor field effect transistor (MOSFET) MP and an N-type metal oxide semiconductor field effect transistor (MOSFET) MN, and may include an inductor L, a converter resistor Rp, and a converter capacitor Co.

The DC-DC converter 210 may be provided through the controller 100 with one or more of a first control signal PD and a second control signal ND, and may convert the power voltage VDD into a direct current (DC) voltage having a different level. The DC-DC converter 210 generates a DC voltage whose level is less than a level of the power voltage VDD. The DC-DC converter 210 may generate an output voltage Vo as an output. The output voltage Vo may be connected or provided to a first node N1.

In some embodiments, the power voltage VDD may be applied to one end (e.g., source) of the P-type MOSFET MP. A third node N3 may be connected to another end (e.g., drain) of the p-type MOSFET MP. A first control signal PD may be provided to a gate of the P-type MOSFET MP.

In some embodiments, the third node N3 may be connected to one end (e.g., drain) of the N-type MOSFET MN. A ground power GND may be applied to another end (e.g., source) of the N-type MOSFET MN. A second control signal ND may be provided to a gate of the N-type MOSFET MN.

In some embodiments, based on the first control signal PD, the DC-DC converter 210 may control the P-type MOSFET MP. Based on the second control signal ND, the DC-DC converter 210 may control the N-type MOSFET MN. The DC-DC converter 210 may control the P-type MOSFET MP and the N-type MOSFET MN to convert the power voltage VDD into a voltage having a different level.

The P-type MOSFET MP and the N-type MOSFET MN may share the third node N3. For example, a drain electrode of the P-type MOSFET MP and a drain electrode of the N-type MOSFET MN may be connected to each other by sharing the third node N3. The third node N3 may also be connected to a first line LX.

In some embodiments, a voltage converted by the P-type MOSFET MP and the N-type MOSFET MN may be provided through the first line LX. The converted voltage provided through the first line LX may drop to an intermediate voltage Vo1 on passing through the inductor L. A potential between the converter resistor Rp and the inductor L connected to the first line LX may be Vo1. The output voltage Vo may be generated as a result of the passing of the intermediate voltage Vo1 through the converter resistor Rp. The converter capacitor Co may charge or discharge electric charge that corresponds to the output voltage Vo.

Based on information about a variation in voltage provided by the sense circuit 300, the controller 100 may output the first control signal PD to allow the P-type MOSFET MP to turn on for a period of time longer than that of the N-type MOSFET MN. Accordingly, the converter capacitor Co may be recharged, and the output voltage Vo may rise again to a level required for a system. Similarly, when a required current of the system is instantaneously reduced, the N-type MOSFET MN may be turned on for a period of time longer than that of the P-type MOSFET MP.

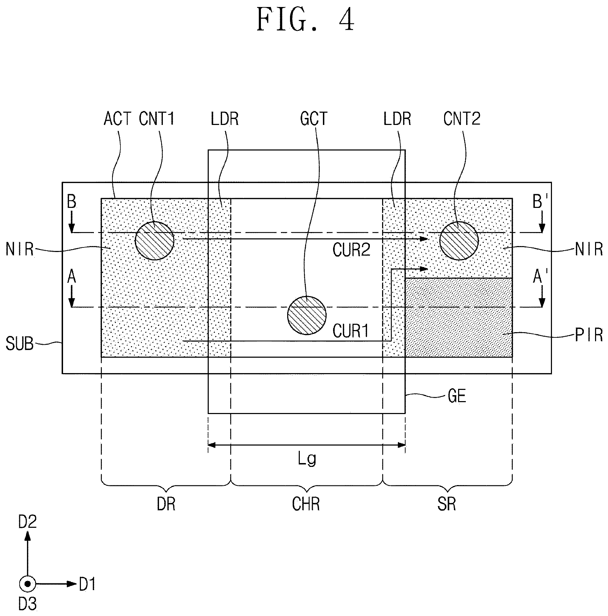

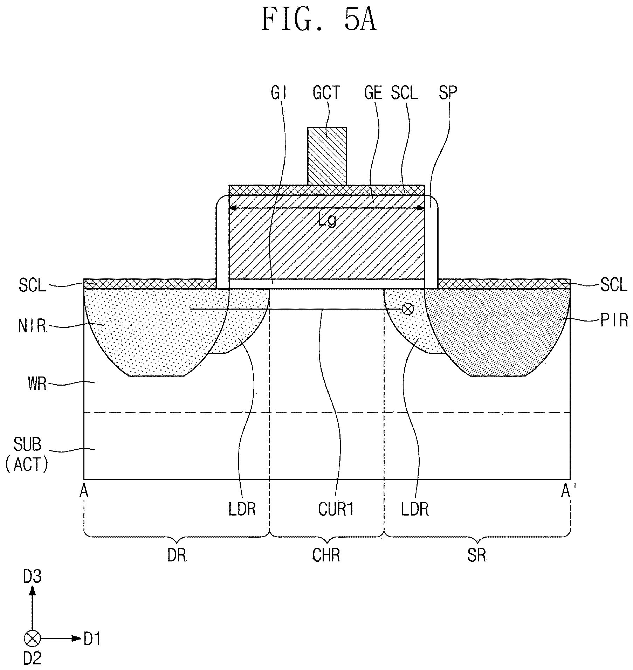

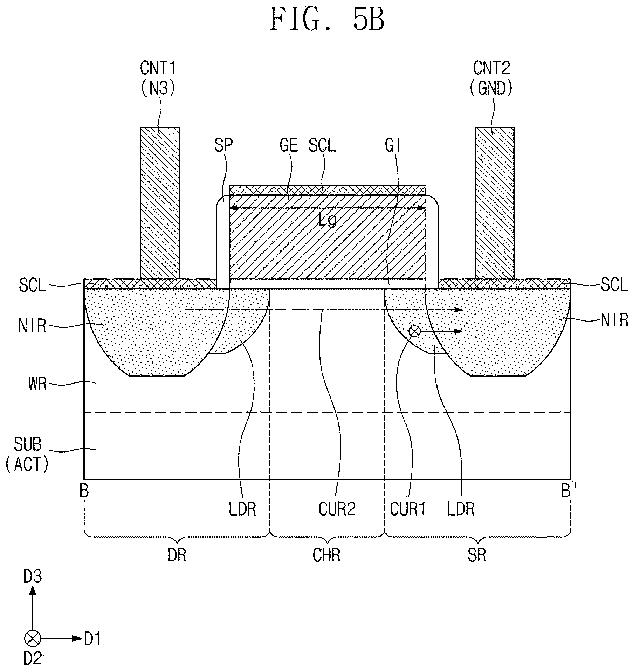

FIG. 4 illustrates a plan view showing a semiconductor device according to some embodiments. FIGS. 5A and 5B illustrate cross-sectional views respectively taken along lines A-A' and B-B' of FIG. 4. A complementary metal oxide semiconductor (CMOS) may be constituted by the P-type MOSFET MP and the N-type MOSFET MN of FIG. 3. The CMOS may include a plurality of PMOSFETs and a plurality of NMOSFETs. A semiconductor device shown in FIGS. 4, 5A, and 5B is represented by way of example as one of a plurality of transistors included in the CMOS.

Referring to FIGS. 4, 5A, and 5B, a semiconductor substrate SUB may be provided which includes an active section ACT. The semiconductor substrate SUB may be a bulk silicon substrate, a silicon-on-insulator (SOI) substrate, a germanium substrate, a germanium-on-insulator (GOI) substrate, a silicon-germanium substrate, or a substrate of a thin epitaxial layer obtained by performing selective epitaxial growth (SEG).

A well impurity layer WR may be provided in the semiconductor substrate SUB. The well impurity layer WR may be positioned in an upper portion of the semiconductor substrate SUB. The well impurity layer WR may be formed by implanting the semiconductor substrate SUB with first impurities (e.g., boron). The doped first impurities may allow the well impurity layer WR to have a first conductivity type.

When an NMOS transistor is adopted as a semiconductor device according to some embodiments, the well impurity layer WR may have a P-type as the first conductivity type. For example, a concentration of the first impurities (e.g., boron (B)) in the well impurity layer WR may range from about 1.0E16 atoms/cm³ to about 1.0E17 atoms/cm³. When a PMOS transistor is adopted as a semiconductor device according to some embodiments, the well impurity layer WR may have an N-type as the first conductivity type.

A gate electrode GE is disposed on the active section ACT. For example, the gate electrode GE may extend in a second direction D2 while running across the active section ACT. A gate dielectric layer GI may be provided between the gate electrode GE and the active section ACT.

The gate electrode GE may include at least one of a doped semiconductor, a conductive metal nitride, or a metal. In an embodiment, the gate electrode GE may include doped polysilicon. The gate electrode GE may further include a conductive metal nitride layer and a metal layer that are stacked on a polysilicon layer.

The gate dielectric layer GI may include a silicon oxide layer, a high-k dielectric layer, or a multiple layer in which a silicon oxide layer and a high-k dielectric layer are sequentially stacked. The high-k dielectric layer may include a high-k dielectric material whose dielectric constant is greater than that of a silicon oxide layer. For example, the high-k dielectric layer may include at least one of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate. In some embodiments, the gate dielectric layer GI may include a thermal oxide layer formed by thermally oxidizing a top surface of the semiconductor substrate SUB.

The active section ACT includes a source region SR and a drain region DR that are correspondingly provided on opposite sides of the gate electrode GE. The source region SR is adjacent to one side of the gate electrode GE, and the drain region DR is adjacent to another side of the gate electrode GE. The source and drain regions SR and DR may be disposed in the well impurity layer WR.

The drain region DR includes a first impurity region NIR and may include a lightly doped impurity region LDR that extends from the first impurity region NIR toward a location below the gate electrode GE.

The first impurity region NIR and the lightly doped impurity region LDR have a second conductivity type (e.g., N-type). The first impurity region NIR and the lightly doped impurity region LDR may include second impurities (e.g., phosphorus (P)). A concentration of the second impurities in the first impurity region NIR may range from about 1.0E20 atoms/cm³ to about 1.0E21 atoms/cm³. The concentration of the second impurities in the first impurity region NIR may be greater than a concentration of the second impurities in the lightly doped impurity region LDR.

The source region SR further includes a second impurity region PIR in addition to the first impurity region NIR and the lightly doped impurity region LDR (best seen in FIG. 4). A description of the first impurity region NIR and the lightly doped impurity region LDR of the source region SR may be substantially the same as the description of the first impurity region NIR and the lightly doped impurity region LDR of the drain region DR discussed above and thus a repeated description thereof is omitted for conciseness. Referring back to FIG. 4, the second impurity region PIR in the source region SR may be disposed to contact the first impurity region NIR. The lightly doped impurity region LDR of the source region SR may extend in the second direction D2 from the second impurity region PIR to the first impurity region NIR.

The second impurity region PIR of the source region SR has the first conductivity type (e.g., P-type). The second impurity region PIR may include the first impurities (e.g., boron (B)). A concentration of the first impurities in the second impurity region PIR may range from about 1.0E20 atoms/cm³ to about 1.0E21 atoms/cm³.

The gate electrode GE may be provided with gate spacers SP on opposite sidewalls thereof in the first direction D1. The gate spacers SP may be correspondingly disposed on the source and drain regions SR and DR. The gate spacers SP may include a dielectric material, such as one or more of silicon oxide and silicon nitride.

The active section ACT may further include a channel region CHR, having the first conductivity type (e.g., P-type), provided below the gate electrode GE. A top surface of the channel region CHR may be in contact with a bottom surface of the gate dielectric layer GI. The channel region CHR may be interposed between the source and drain regions SR and DR that are spaced apart from each other. In some embodiments, a length in the first direction D1 of the channel region CHR may be a first length Lg as a gate length. In some embodiments, the length in the first direction D1 of the channel region CHR may be less than the first length Lg of the gate length.

The channel region CHR may include the first impurities (e.g., boron (B)) to have the first conductivity type (e.g., P-type). In an embodiment, a concentration of the first impurities in the channel region CHR may be greater than the concentration of the first impurities in the well impurity layer WR and less than the concentration of the first impurities in the second impurity region PIR. For example, the concentration of the first impurities in the channel region CHR may range from about 1.0E16 atoms/cm³ to about 1.0E17 atoms/cm³.

A silicide layer SCL may be provided on each of the drain region DR, the source region SR, and the gate electrode GE. The silicide layer SCL may include a metal-semiconductor compound. For example, the silicide layer SCL may include at least one of titanium silicide, tantalum silicide, tungsten silicide, nickel silicide, or cobalt silicide.

The first impurity region NIR and the second impurity region PIR may be connected at a same potential through the silicide layer SCL on the source region SR. For example, the first and second impurity regions NIR and PIR in the source region SR may be electrically connected through the silicide layer SCL.

A first contact CNT1 may be provided on the drain region DR, and a second contact CNT2 may be provided on the source region SR. A gate contact GCT may be provided on the gate electrode GE. The first contact CNT1 may be electrically connected through the silicide layer SCL to the drain region DR. The second contact CNT2 may be electrically connected through the silicide layer SCL to the source region SR. The gate contact GCT may be electrically connected through the silicide layer SCL to the gate electrode GE.

Referring back to FIG. 3, the ground power GND may be applied through the second contact CNT2 to the source region SR. The drain region DR may be connected through the first contact CNT1 to the third node N3. The second control signal ND may be provided through the gate contact GCT to the gate electrode GE.

The second impurity region PIR according to some embodiments may serve as a P-body tap. The second impurity region PIR increases a snapback breakdown voltage of a transistor according to some embodiments. For example, the second impurity region PIR may increase endurance of a transistor to prevent issues such as a burnt failure or electrical over stress (EOS). However, the second impurity region PIR may increase a specific on-resistance of the transistor to cause problems such as degradation in electrical properties.

When turning on the transistor according to some embodiments, a current may flow from the drain region DR toward the source region SR. For example, a second current CUR2 may directly flow from the drain region DR toward the first impurity region NIR of the source region SR. A first current CUR1 may flow from the drain region DR toward the first impurity region NIR of the source region SR. For example, the first current CUR1 may bypass the second impurity region PIR and flow through the lightly doped impurity region LDR toward the first impurity region NIR of the source region SR. Therefore, a path of the first current CUR1 may be longer than a path of the second current CUR2. Since the first current CUR1 has a relatively longer path, a current loss may be induced and a specific on-resistance may be increased.

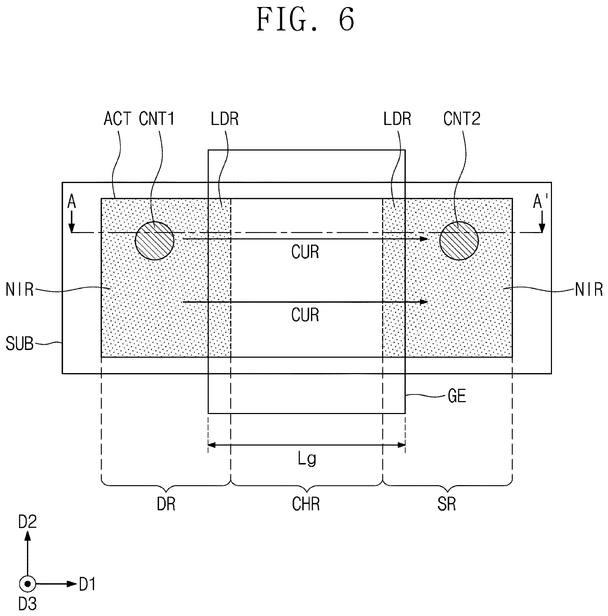

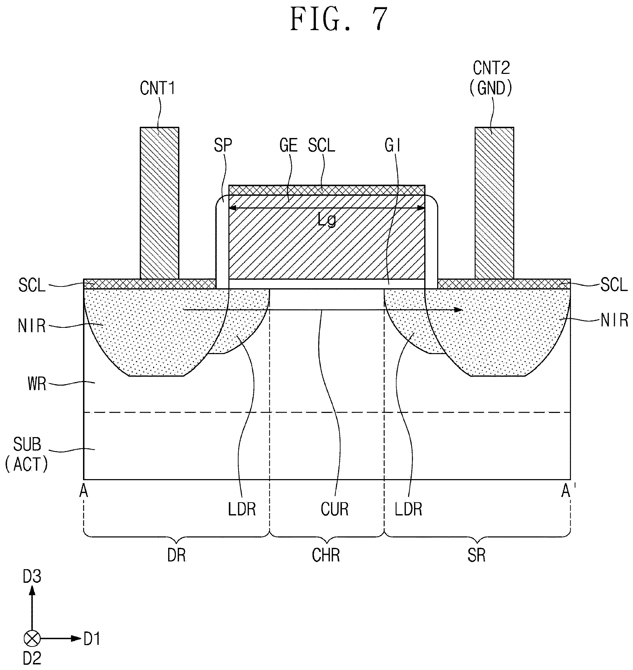

FIG. 6 illustrates a plan view showing a semiconductor device according to a comparative example. FIG. 7 illustrates a cross-sectional view taken along line A-A' of FIG. 6. Referring to FIGS. 6 and 7, the second impurity region PIR may be omitted from the source region SR according to the comparative example. For example, according to the comparative example, the source region SR may include only the first impurity region NIR and the lightly doped impurity region LDR.

When turning on a transistor according to the comparative example, a current CUR may flow from the drain region DR toward the source region SR. Since the second impurity region PIR is omitted from the source region SR, all current CUR may directly flow from the drain region DR toward the source region SR. For example, the current CUR may move along the shortest path from the drain region DR to the source region SR.

Compared to a transistor according to some embodiments, a transistor according to the comparative example may have reduced current loss and decreased specific on-resistance. In contrast, the transistor according to a comparative example may experience an excessive dropdown in snapback breakdown voltage. Accordingly, a burnt failure may easily occur in the transistor according to the comparative example.

In a semiconductor device according to the claimed invention, the source region SR includes the second impurity region PIR as well as the first impurity region NIR, and thus a drop in snapback breakdown voltage is prevented. However, the second impurity region PIR may cause an increase in specific on-resistance. In other words, there may be a trade-off relationship between a drop in snapback breakdown voltage and an increase in specific on-resistance.

The second impurity region is made of segmented second impurity regions concentrated on a vulnerable region of a transistor. Hence, embodiments may prevent both a reduction in snapback breakdown voltage and an excessive increase in specific on-resistance.

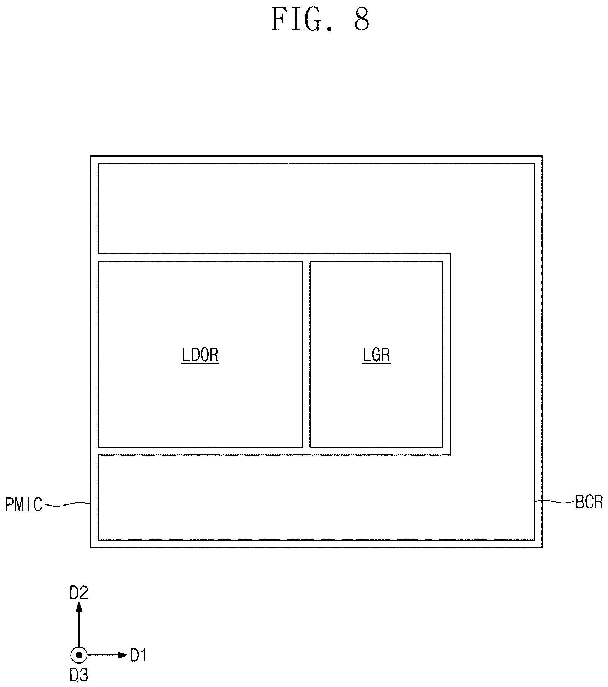

FIG. 8 illustrates a plan view showing a power management integrated circuit chip according to some embodiments. Referring to FIG. 8, a power management integrated circuit chip PMIC according to some embodiments includes a buck converter region BCR, a low-dropout regulator region LDOR, and a logic circuit region LGR. For example, the logic circuit region LGR may constitute the controller 100 of FIG. 2. In other words, the controller 100 of FIG. 2 may be implemented in the logic circuit region LGR. The buck converter region BCR includes a buck converter and may include a plurality of DC-DC converters (see 210 of FIG. 3). The buck converter region BCR may be the largest area in the power management integrated circuit chip PMIC. Therefore, a fineness of the buck converter region BCR may directly affect integration of the power management integrated circuit chip PMIC.

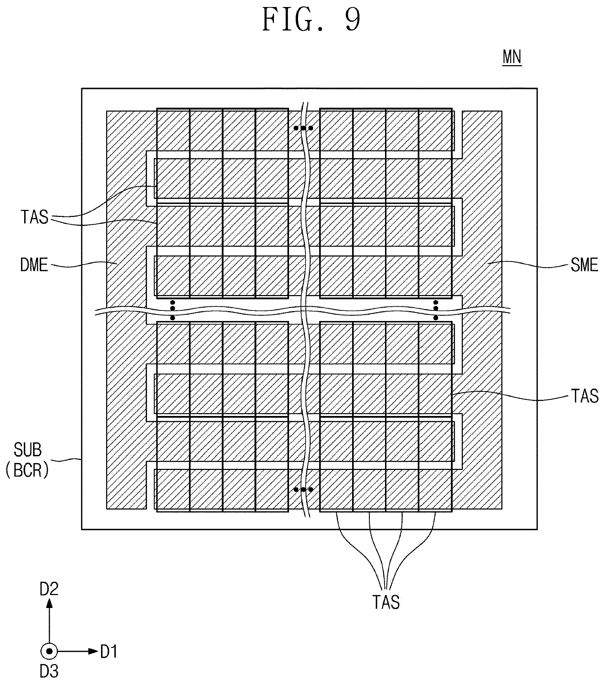

FIG. 9 illustrates a plan view of one DC-DC buck converter in the buck converter region of FIG. 8, according to some embodiments. FIG. 9 is a plan view showing the N-type MOSFET MN of the DC-DC converter 210 of FIG. 3.

Referring to FIG. 9, the N-type MOSFET MN includes a plurality of transistor sets TAS that are two-dimensionally arrayed on a substrate SUB. For example, about 100 transistor sets TAS to about 500 transistor sets TAS may be two-dimensionally arranged to constitute a single giant N-type MOSFET MN. FIG. 9 shows 32 transistor sets TAS by way of example for clarity and ease of explanation.

A source electrode SME and a drain electrode DME are provided on a plurality of transistor sets TAS. The source electrode SME and the drain electrode DME may each have an inter-digital electrode shape. In some embodiments, the source electrode SME may have a plurality of fingers (e.g., extending to the left in the first direction D1 in FIG. 9) and the drain electrode DME may have a plurality of fingers (e.g., extending to the right in the first direction in FIG. 9), where the fingers of the source electrode SME and the fingers of the drain electrode DME are interlaced with each other in the second direction D2. In some embodiments, each transistor set TAS may cross the source electrode SME and the drain electrode DME. In some embodiments, each transistor set TAS may cross a portion of the source electrode SME and a portion of the drain electrode DME as illustrated in FIG. 9.

The source electrode SME may be connected in common to sources of the plurality of transistor sets TAS. The drain electrode DME may be connected in common to drains of the plurality of transistor sets TAS. The source electrode SME may be connected to the ground power GND of FIG. 4, and the drain electrode DME may be connected to the third node N3 of FIG. 3.

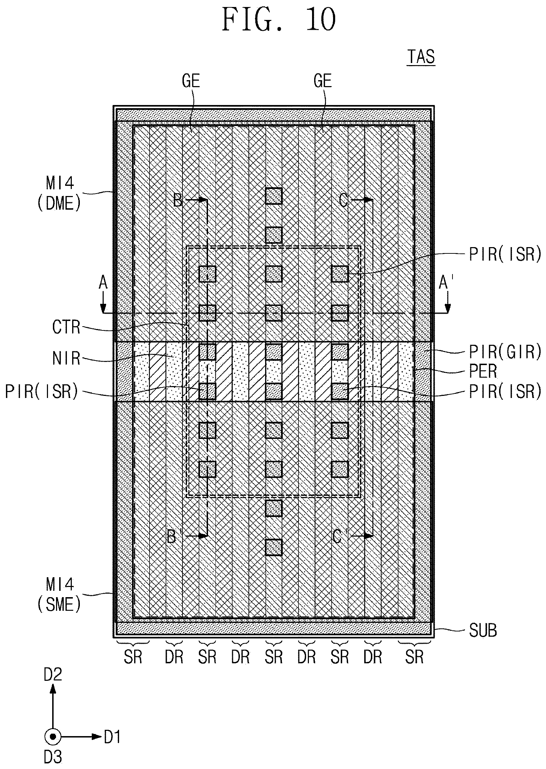

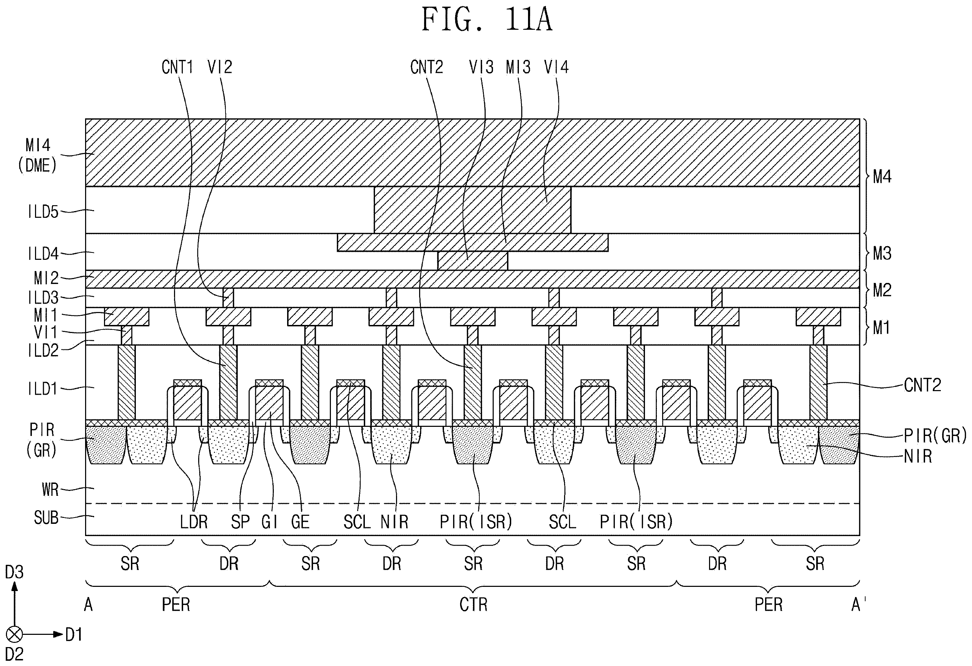

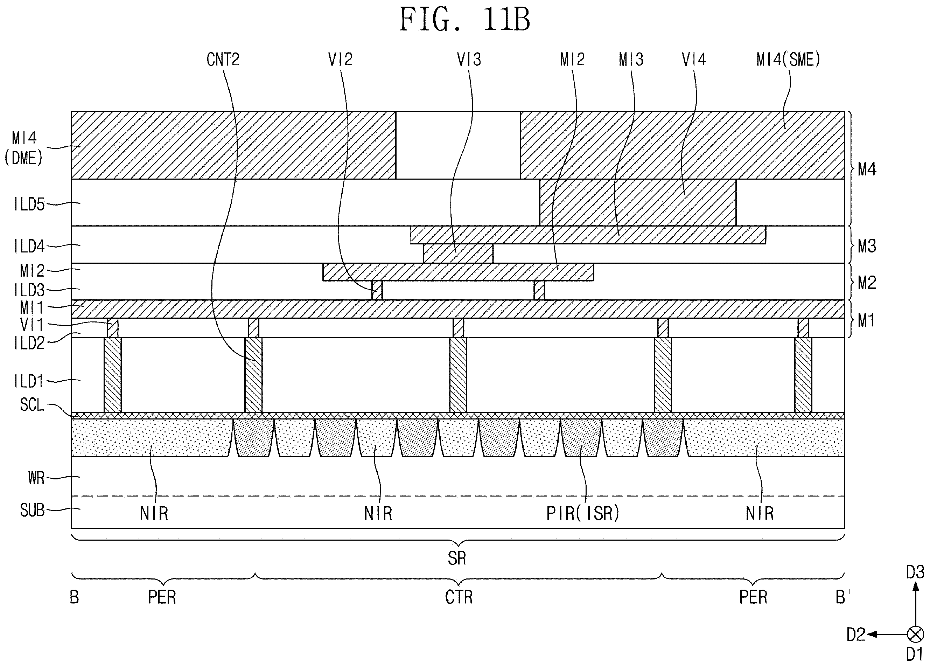

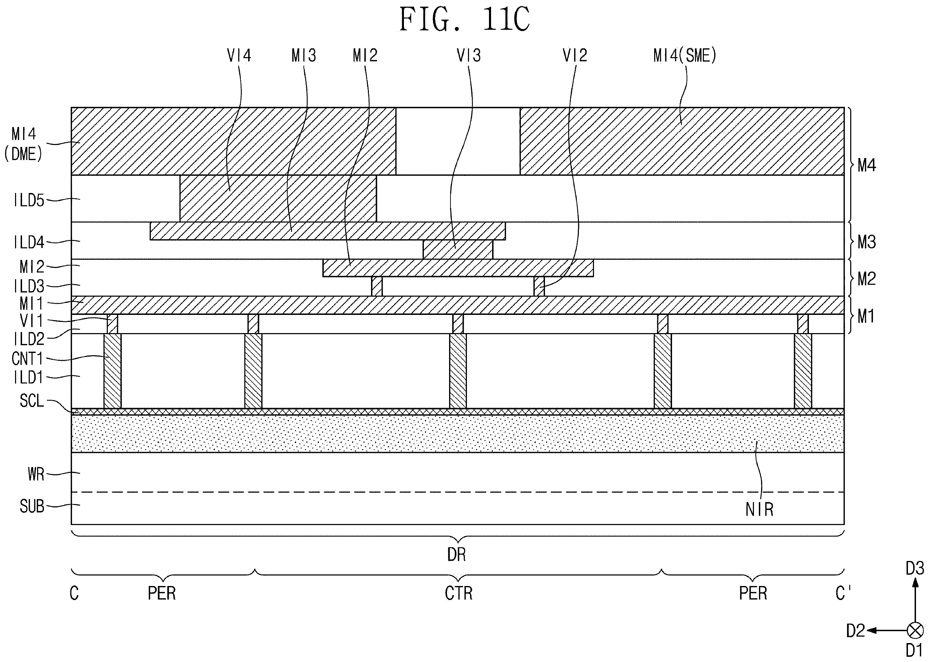

FIG. 10 illustrates an enlarged plan view showing one transistor set of FIG. 9 according to some embodiments. FIGS. 11A, 11B, and 11C illustrate cross-sectional views respectively taken along lines A-A', B-B', and C-C' of FIG. 10.

Referring to FIGS. 10 and 11A to 11C, a transistor set TAS includes a source region, a drain region and a gate electrode between the source region and drain region. The transistor set includes a plurality of source regions SR and a plurality of drain regions DR on a substrate SUB. The source regions SR and the drain regions DR may be provided in an upper portion of a well impurity layer WR of the substrate SUB. Each of the source and drain regions SR and DR may have a linear or bar shape that extends in a second direction D2. The source and drain regions SR and DR may be alternately arranged along a first direction D1.

A plurality of gate electrodes GE are provided on the substrate SUB.
According to the example illustrated in FIGS. 10-11C, eight gate electrodes GE may be provided. The gate electrodes GE may extend in parallel to each other in the second direction D2.

Each of the drain regions DR includes a first impurity region NIR and may include a lightly doped impurity region LDR. Each of the source regions SR further includes at least one second impurity region PIR in addition to the first impurity region NIR and the lightly doped impurity region LDR.

The second impurity region PIR may include a guard ring region GIR and includes a plurality of segment regions ISR. The guard ring region GIR of the second impurity region PIR may surround an edge of the transistor set TAS. For example, the guard ring region GIR of the second impurity region PIR may have a guard ring shape that surrounds the transistor set TAS. The guard ring region GIR may define a boundary of the transistor set TAS.

The plurality of segment regions ISR of the second impurity region PIR may each have an island shape (or a square shape in FIG. 10). In one source region SR, the segment regions ISR may be disposed spaced apart from each other in the second direction D2. In the example illustrated in FIG. 10, there are six segment regions ISR spaced apart from each other in the second direction D2 in two of the source regions SR and ten (10) segment regions ISR spaced apart from each other in the second direction D2 in one of the source regions SR. However, this is only an example and, in some embodiments, the number of segment regions ISR in the source regions SR may be different.

The number of the segment regions ISR is different on different source regions SR. For example, the source region SR on a center of the transistor set TAS may include the largest number of the segment regions ISR. The source region SR on the center of the transistor set TAS may include ten segment regions ISR, as in the example illustrated in FIG. 10. Other source regions SR of the transistor set TAS may include six segment regions ISR, as in the example illustrated in FIG. 10.

The transistor set TAS includes a central region CTR and a peripheral region PER that surrounds the central region CTR. In other words, the peripheral region PER may be a border of the transistor set TAS, and the central region CTR may be in the middle of the transistor set TAS. A length in the first direction D1 of the central region CTR may be defined to include m/2 gate electrodes GE centrally arranged among m gate electrodes GE of the transistor set TAS. A length in the second direction D2 of the central region CTR may be defined to be half a length in the second direction D2 of the transistor set TAS.

The number of the segment regions ISR of the second impurity region PIR in the central region CTR may be greater than the number of the segment regions ISR of the second impurity region PIR in the peripheral region PER. For example, in the example illustrated in FIG. 10, the number of the segment regions ISR in the central region CTR may be about 18, and the number of the segment regions ISR in the peripheral region PER may be about 4. According to claim 1, a first density of the segment regions ISR in the central region CTR is greater than a second density of the segment regions ISR in the peripheral region PER.

The term "density" indicates the number of the segment regions ISR per unit area of a related region. For example, the central region CTR may have an area of about 2 µm², and the peripheral region PER may have an area of about 3 µm². In this case, the segment regions ISR of the central region CTR may have a density of about 9 /µm² (18 segment regions ISR / 2 µm²) The segment regions ISR of the peripheral region PER may have a density of about 1.333 /µm² (4 segment regions ISR / 3 µm²). In some embodiments, the term "density" may denote a total area of the segment regions ISR per unit area of a related region.

The central region CTR of the transistor set TAS may be a vulnerable region where there is an excessive dropdown in snapback breakdown voltage. A thermal disturbance generated in the substrate SUB, a potential imbalance caused by line resistance, and a mechanical stress resulting from the source and drain electrodes SME and DME, a drop in snapback breakdown voltage may be greater on the central region CTR than on the peripheral region PER of the transistor set TAS.

The following will describe in detail the effect of a breakdown voltage caused by mechanical stress resulting from the source and drain electrodes SME and DME. On a zone between the source and drain electrodes SME and DME, or a zone that does not overlap any of the source and drain electrodes SME and DME (i.e., a lightly shaded region in FIG. 10), a strong tensile stress may be applied to the substrate SUB. The central region CTR of the transistor set TAS may be positioned between the source and drain electrodes SME and DME. Therefore, a transistor in the central region CTR may experience a breakdown voltage drop caused by tensile stress.

In some embodiments, the central region CTR may be defined to refer to a zone between the source and drain electrodes SME and DME in the transistor set TAS. For example, the central region CTR may be defined to refer to a zone that does not overlap any of the source and drain electrodes SME and DME. In some embodiments, the density of the segment regions ISR in the central region CTR may be greater than a density of the segment regions ISR in a zone other than the central region CTR.

According to some embodiments, as discussed above by comparing the transistor of FIG. 4 with the transistor of FIG. 6, the second impurity region PIR may increase a snapback breakdown voltage, but may decrease a specific on-resistance. Therefore, the second impurity region PIR is divided into a plurality of segment regions ISR, and the plurality of segment regions ISR according to claim 1 is concentrated on the central region CTR as a vulnerable region where a breakdown voltage is reduced. The segment regions ISR according to claim 1 is disposed at low density on the peripheral region PER where there is no drop in breakdown voltage. Therefore, some embodiments may prevent a burnt failure caused by drop in a breakdown voltage of the transistor set TAS and simultaneously may suppress a large reduction in a specific on-resistance.

A silicide layer SCL may be provided on each of the source and drain regions SR and DR. The silicide layer SCL may also be provided on each of the gate electrodes GE. A first interlayer dielectric layer ILD1 may be provided on the gate electrodes GE and the source and drain regions SR and DR.

First contacts CNT1 may be correspondingly provided on the drain regions DR. Second contacts CNT2 may be correspondingly provided on the source regions SR. Gate contacts GCT may be correspondingly provided on the gate electrodes GE (see FIG. 5A). The contacts CNT1, CNT2, and GCT may penetrate the first interlayer dielectric layer ILD1.

The contacts CNT1, CNT2, and GCT may be provided on a first metal layer M1, a second metal layer M2, a third metal layer M3, and a fourth metal layer M4 that are sequentially stacked. The first metal layer M1 may include a second interlayer dielectric layer ILD2 and first wiring lines MI1 provided in the second interlayer dielectric layer ILD2. The first wiring lines MI1 may be electrically connected through first vias VI1 to the contacts CNT1, CNT2, and GCT.

The second metal layer M2 may include a third interlayer dielectric layer ILD3 and second wiring lines MI2 provided in the third interlayer dielectric layer ILD3. The second wiring line MI2 may be electrically connected through a second via VI2 to the first wiring line MI1.

The third metal layer M3 may include a fourth interlayer dielectric layer ILD4 and third wiring lines MI3 provided in the fourth interlayer dielectric layer ILD4. The third wiring line MI3 may be electrically connected through a through via VI3 to the second wiring line MI2.

The fourth metal layer M4 may include a fifth interlayer dielectric layer ILD5 and fourth wiring lines MI4 provided in the fifth interlayer dielectric layer ILD5. The fourth wiring line MI4 may be electrically connected through a fourth via VI4 to the third wiring line MI3.

In some embodiments, the fourth wiring lines MI4 may include a source electrode SME and a drain electrode DME. The drain electrode DME may be connected in common to a plurality of drain regions DR of the transistor set TAS through the first contacts CNT1 and the first to third metal layers M1 to M3 (see FIG. 11C). The source electrode SME may be connected in common to a plurality of source regions SR of the transistor set TAS through the second contacts CNT2 and the first to third metal layers M1 to M3 (see FIG. 11B).

The fourth wiring lines MI4 of the fourth metal layer M4 may have their line-widths and thicknesses greater than line-widths and thicknesses of the first to third wiring lines MI1 to MI3 below the fourth wiring lines MI4. Therefore, the fourth wiring lines MI4 be caused to apply a stress to the substrate SUB. As discussed above, a strong tensile stress may be applied to a zone between the fourth wiring lines MI4, and the zone may be formed into a vulnerable region where a breakdown voltage is reduced. According to claim 1, the segment regions ISR of the second impurity region PIR are concentrated on the vulnerable region, and thus the vulnerable region may be prevented from the breakdown voltage drop.

The transistor set TAS according to an embodiment with reference to FIGS. 10 and 11A to 11C is illustrated as a portion included in the N-type MOSFET MN of FIG. 3. The transistor set TAS of some embodiments may also be identically applicable to the P-type MOSFET MP.

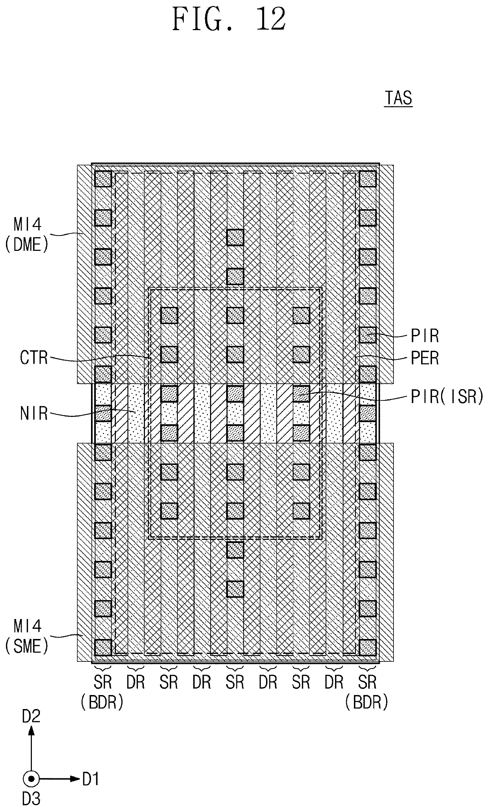

FIGS. 12 to 15 illustrate enlarged plan views showing one transistor set of FIG. 9 according to some embodiments. In the embodiments that follow, a detailed description of technical features repetitive to those discussed above with reference to FIGS. 10 and 11A to 11C will be omitted for conciseness, and a difference thereof will mainly be discussed in detail.

Referring to FIG. 12, the guard ring region GIR of the second impurity region PIR may be omitted. The segment regions ISR of the second impurity region PIR may be provided on an outermost source region SR, or a boundary region BDR. Similar to the segment regions ISR on the central region CTR, the segment regions ISR on the boundary region BDR may be disposed at high density. Neighboring transistor sets TAS may be separated from each other through the segment regions ISR on the boundary region BDR.

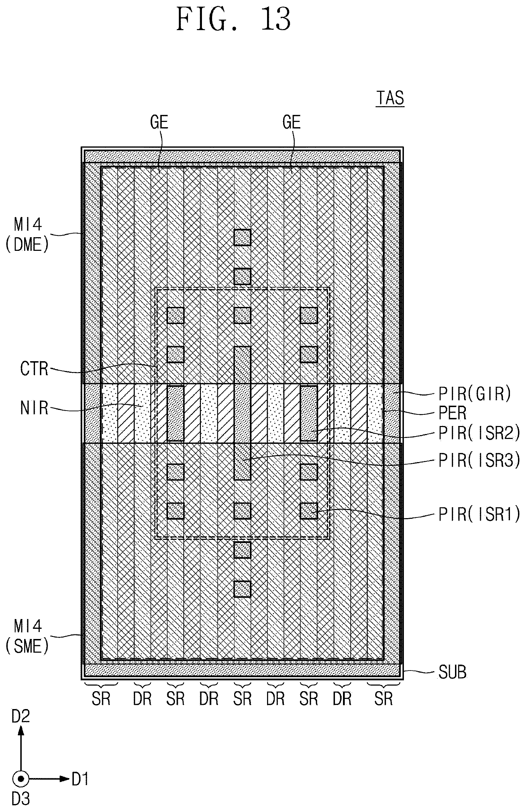

Referring to FIG. 13, the segment regions ISR of the second impurity region PIR may include a first segment region ISR1, a second segment region ISR2, and a third segment region ISR3.

The second segment region ISR2 may be larger than the first segment region ISR1.The third segment region ISR3 may be larger than the second segment region ISR2.For example, a length in the second direction D2 of the second segment region ISR2 may be greater than a length in the second direction D2 of the first segment region ISR1.A length in the second direction D2 of the third segment region ISR3 may be greater than the length in the second direction D2 of the second segment region ISR2.

The first segment region ISR1 may be provided in the central region CTR or the peripheral region PER. The second segment region ISR2 and the third segment region ISR3 may be provided only in the central region CTR. The third segment region ISR3 may be provided in the source region SR at a center of the transistor set TAS. The second segment region ISR2 may be provided in another source region SR adjacent to the central source region SR.

The segment regions ISR of the second impurity region PIR may have sizes that increase in a direction toward the center of the transistor set TAS. Since the degree of drop in breakdown voltage is increased in a direction toward the center of the transistor set TAS, the drop in breakdown voltage may be prevented by allowing the segment regions ISR to have sizes that increase in a direction toward the center of the transistor set TAS.

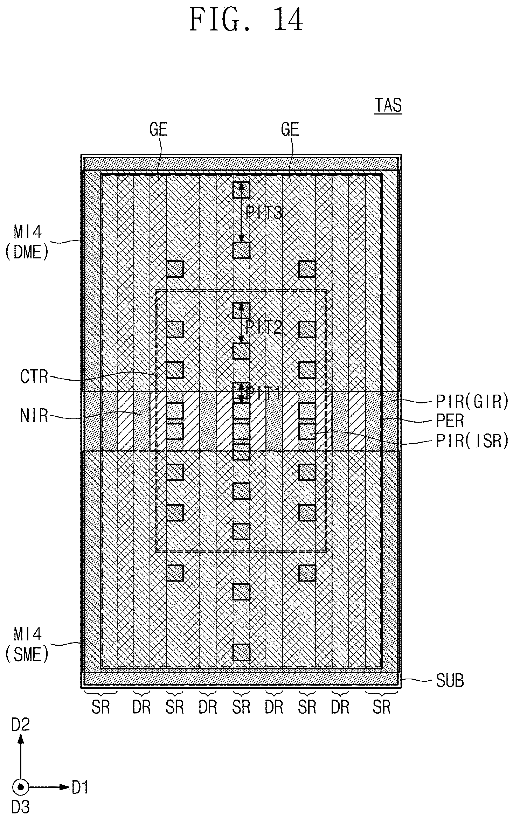

Referring to FIG. 14, there may be a variation in pitch (or interval) between neighboring segment regions ISR of the second impurity region PIR. For example, a plurality of segment regions ISR in a central source region SR may be arranged spaced apart from each other along the second direction D2. A first pitch PIT1 may be provided as an interval between neighboring segment regions ISR in the zone between the source electrode SME and the drain electrode DME in the central region CTR. A second pitch PIT2 may be provided as an interval between the segment regions ISR adjacent to the zone between the source electrode SME and the drain electrode DME in the central region CTR. The second pitch PIT2 may be greater than the first pitch PIT1. A third pitch PIT3 may be provided as an interval between neighboring segment regions ISR in the peripheral region PER. The third pitch PIT3 may be greater than the second pitch PIT2.

According to some embodiments, the segment regions ISR may have pitches that decrease in a direction toward a center of the transistor set TAS, and thus it may be possible to maximize a difference in density of the segment regions ISR in the central region CTR and density of the segment regions ISR in the peripheral region PER. The arrangement of the segment regions ISR may effectively prevent both a drop in a snapback breakdown voltage and an increase in a specific on-resistance.

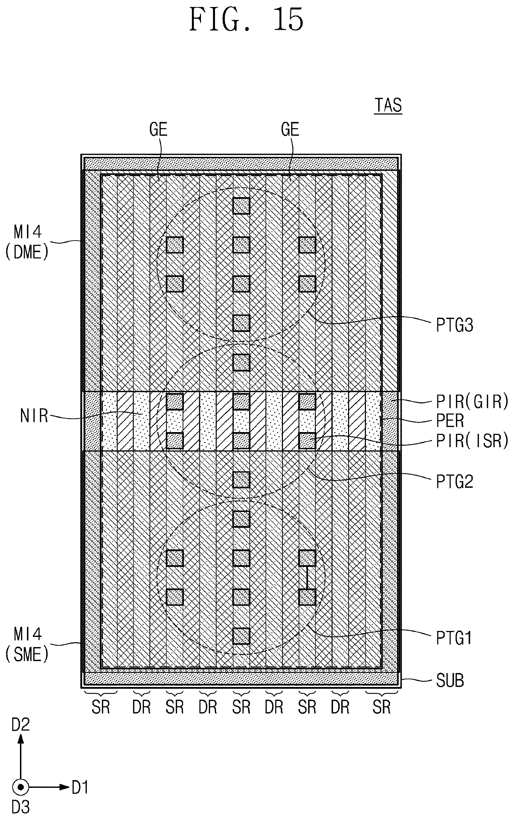

Referring to FIG. 15, the segment regions ISR of the second impurity regions PIR may constitute segment groups PTG1 to PTG3. In an embodiment, the segment groups PTG1 to PTG3 may include a plurality of segment regions ISR that are arranged in a diamond shape. For example, first, second, and third segment groups PTG1, PTG2, and PTG3 may be arranged along the second direction D2 in the transistor set TAS. The first, second, and third segment groups PTG1, PTG2, and PTG3 may have a same pattern shape. The second segment group PTG2 may be disposed on a central portion of the transistor set TAS.

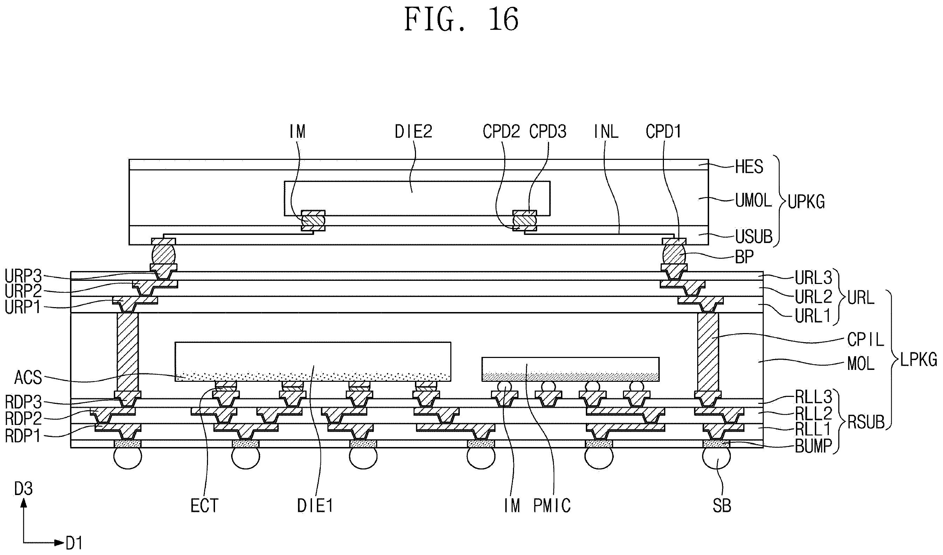

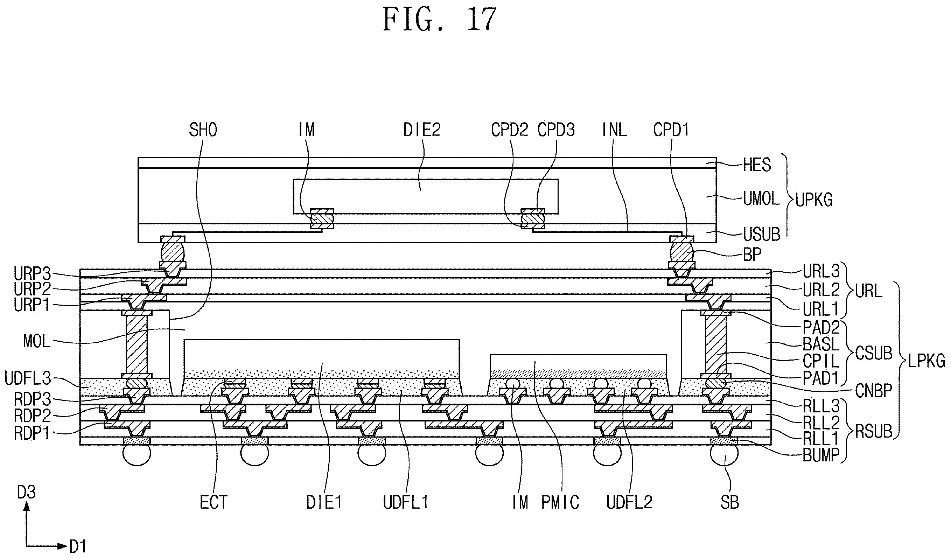

FIGS. 16 and 17 illustrate cross-sectional views showing a semiconductor package including a power management integrated circuit according to some embodiments.

Referring to FIG. 16, a semiconductor package according to some embodiments may include a lower semiconductor package LPKG and an upper semiconductor package UPKG. The lower semiconductor package LPKG may include a redistribution substrate RSUB, second external terminals SB, connection terminals IM, a power management integrated circuit chip PMIC according to some embodiments, a first die DIE1, a molding layer MOL, conductive pillars CPIL, and an upper redistribution layer URL.

The redistribution substrate RSUB may include a first redistribution layer RLL1, a second redistribution layer RLL2, and a third redistribution layer RLL3 that are sequentially stacked. The first redistribution layer RLL1 may include first redistribution patterns RDP1. The second redistribution layer RLL2 may include second redistribution patterns RDP2. The third redistribution layer RLL3 may include lower bonding pads RDP3. Each of the lower bonding pads RDP3 may have an upper portion that protrudes upwardly from the third redistribution layer RLL3. The first redistribution patterns RDP1, the second redistribution patterns RDP2, and the lower bonding pads RDP3 may each include a seed pattern and a conductive pattern on the seed pattern.

A plurality of bump patterns BUMP may be provided below the first redistribution layer RLL1. The bump patterns BUMP may be correspondingly connected to the first redistribution patterns RDP1. A plurality of second external terminals SB may be provided below the bump patterns BUMP. The bump pattern BUMP may lie between and connect to each other the second external terminal SB and the first redistribution pattern RDP1. For example, the second external terminal SB may be a solder ball.

The redistribution substrate RSUB may be provided thereon with the first die DIE1 and the power management integrated circuit chip PMIC according to some embodiments. The first die DIE1 and the power management integrated circuit chip PMIC may be mounted side by side in a first direction D1 on the redistribution substrate RSUB.

In some embodiments, the power management integrated circuit chip PMIC may be disposed below the redistribution substrate RSUB. For example, the power management integrated circuit chip PMIC may be provided below the first redistribution layer RLL1 and mounted at the same level as that of the bump patterns BUMP and the second external terminals SB.

The first die DIE1 may include a logic chip, for example, an application processor (AP). As discussed above with reference to FIG. 1, the power management integrated circuit chip PMIC may provide power to the first die DIE1, and may manage the power in relation to the first die DIE1.

The first die DIE1 may be provided with connection members ECT on an active surface ACS thereof. The connection members ECT may be correspondingly interposed between the first die DIE1 and the lower bonding pads RDP3 of the redistribution substrate RSUB, such that the first die DIE1 and the redistribution substrate RSUB may be electrically connected to each other.

The connection terminals IM may be correspondingly interposed between the power management integrated circuit chip PMIC and the lower bonding pads RDP3 of the redistribution substrate RSUB. The power management integrated circuit chip PMIC and the redistribution substrate RSUB may be electrically connected to each other through the connection terminals IM. For example, the connection members ECT and the connection terminals IM may each include a micro-bump.

At least one conductive pillar CPIL may be provided on the redistribution substrate RSUB. The conductive pillar CPIL may be provided on an edge of the redistribution substrate RSUB. The conductive pillar CPIL may be horizontally spaced apart from the first die DIE1 and the power management integrated circuit chip PMIC.

The conductive pillar CPIL may be connected to its corresponding lower bonding pad RDP3. In this case, the conductive pillar CPIL may be electrically connected to the redistribution substrate RSUB. For example, the conductive pillar CPIL may be electrically connected through the redistribution substrate RSUB to one of the first die DIE1, the power management integrated circuit chip PMIC, and the second external terminal SB. The conductive pillar CPIL may be a metallic column including metal such as copper.

The molding layer MOL may be provided on the redistribution substrate RSUB to cover the first die DIE1 and the power management integrated circuit chip PMIC. The molding layer MOL may cover a sidewall of the conductive pillar CPIL. The sidewall of the molding layer MOL may be aligned with that of the redistribution substrate RSUB. The molding layer MOL may expose a top surface of the conductive pillar CPIL. For example, the molding layer MOL may include a dielectric polymer, such as an epoxy-based molding compound.

An upper redistribution layer URL may be provided on a top surface of the molding layer MOL. The upper redistribution layer URL may include a first upper redistribution layer URL1, a second upper redistribution layer URL2, and a third upper redistribution layer URL3.

The first upper redistribution layer URL1 may include first upper redistribution patterns URP1. The second upper redistribution layer URL2 may include second upper redistribution patterns URP2. The third upper redistribution layer URL3 may include upper bonding pads URP3. The first upper redistribution pattern URP1 may be connected to the top surface of the conductive pillar CPIL. Each of the upper bonding pads URP3 may protrude upwardly from the third upper redistribution layer URL3. The first, second, and third upper redistribution patterns URP1, URP2, and URP3 may each include a seed pattern and a conductive pattern on the seed pattern.

The upper bonding pads URP3 may be electrically connected through the first and second upper redistribution patterns URP1 and URP2 and the conductive pillars CPIL to one of the first die DIE1, the power management integrated circuit chip PMIC, and the second external terminals SB. As the first and second upper redistribution patterns URP1 and URP2 are provided, the upper bonding pad URP3 may be disposed offset from the conductive pillar CPIL.

The upper semiconductor package UPKG may be provided on the lower semiconductor package LPKG. For example, the upper semiconductor package UPKG may be mounted on the upper redistribution layer URL. The upper semiconductor package UPKG may include an upper substrate USUB, a second die DIE2, and an upper molding layer UMOL. For example, the upper substrate USUB may be a printed circuit board. For another example, the upper substrate USUB may be a redistribution substrate.

A first conductive pad CPD1 and a second conductive pad CPD2 may be respectively disposed on lower and upper sides of the upper substrate USUB. The upper substrate USUB may have therein a wiring line INL coupled to the first conductive pad CPD1 and the second conductive pad CPD2. The wiring line INL is schematically illustrated and may be variously changed in shape and arrangement. The first conductive pad CPD1, the second conductive pad CPD2, and the wiring line INL may include a conductive material, such as metal.

The second die DIE2 may be disposed on the upper substrate USUB. The second die DIE2 may include an integrated circuit (not shown), and the integrated circuit may include a memory circuit, a logic circuit, or a combination thereof. The second die DIE2 may be of a different type from the first die DIE1. For example, the second die DIE2 may be a dynamic random access memory (DRAM) chip. The second conductive pad CPD2 and the second die DIE2 may have therebetween a connection terminal IM that connects the upper substrate USUB to the second die DIE2. The second die DIE2 may be electrically connected to the first conductive pad CPD1 through the connection terminal IM and the wiring line INL.

The upper substrate USUB may be provided thereon with the upper molding layer UMOL that covers the second die DIE2. The upper molding layer UMOL may include a dielectric polymer, such as an epoxy-based polymer.

The upper semiconductor package UPKG may further include a heat emission structure HES. The heat emission structure HES may include a heat sink, a heat slug, or a thermal interface material layer. For example, the heat emission structure HES may include metal. The heat emission structure HES may be disposed on a top surface of the upper molding layer UMOL. The heat emission structure HES may further extend onto a sidewall of the upper molding layer UMOL.

First external terminals BP may be provided between the lower semiconductor package LPKG and the upper semiconductor package UPKG. The first external terminal BP may be interposed between the upper bonding pad URP3 and the first conductive pad CPD1, thereby connecting the lower semiconductor package LPKG to the upper semiconductor package UPKG. For example, the upper semiconductor package UPKG may be electrically connected through the first external terminals BP to one of the first die DIE1, the power management integrated circuit chip PMIC, and the second external terminals SB. An electrical connection with the upper semiconductor package UPKG may mean an electrical connection with an integrated circuit in the second die DIE2. The first external terminal BP may include a solder, a bump, or a combination thereof. The first external terminal BP may include a solder material.

Referring to FIG. 17, a semiconductor package according to some embodiments may include a lower semiconductor package LPKG and an upper semiconductor package UPKG. The lower semiconductor package LPKG may include a redistribution substrate RSUB, second external terminals SB, connection terminals IM, connection bumps CNBP, a power management integrated circuit chip PMIC according to some embodiments, a first die DIE1, a molding layer MOL, and a connection substrate CSUB. The redistribution substrate RSUB, the second external terminals SB, the connection terminals IM, and the molding layer MOL may be identical or similar to those discussed above in FIG. 16.

The lower semiconductor package LPKG may further include a first under-fill layer UDFL1 and a second under-fill layer UDFL2. The first under-fill layer UDFL1 may be provided in a first gap between the redistribution substrate RSUB and the first die DIE1. The first under-fill layer UDFL1 may encapsulate connection members ECT. The second under-fill layer UDFL2 may be provided in a second gap between the redistribution substrate RSUB and the power management integrated circuit chip PMIC, thereby encapsulating the connection terminals IM.

The connection substrate CSUB may be disposed on the redistribution substrate RSUB. The connection substrate CSUB may have a substrate hole SHO that penetrates therethrough. For example, the connection substrate CSUB may be fabricated by forming the substrate hole SHO that penetrates top and bottom surfaces of a printed circuit board. When viewed in plan, the substrate hole SHO may overlap a central portion of the redistribution substrate RSUB. The first die DIE1 and the power management integrated circuit chip PMIC may be disposed in the substrate hole SHO of the connection substrate CSUB. The power management integrated circuit chip PMIC and the first die DIE1 may be spaced apart from an inner sidewall of the connection substrate CSUB.

The connection substrate CSUB may include a base layer BASL and a conductive pillar CPIL. The base layer BASL may include a single layer or a multiple layer. The base layer BASL may include a dielectric material. For example, the base layer BASL may include a carbon-based material, a ceramic, or a polymer. The conductive pillar CPIL may be provided in the base layer BASL. The connection substrate CSUB may further include a first pad PAD1 and a second pad PAD2. The first pad PAD1 may be disposed on a bottom surface of the conductive pillar CPIL. The second pad PAD2 may be disposed on a top surface of the conductive pillar CPIL. The second pad PAD2 may be electrically connected through the conductive pillar CPIL to the first pad PAD1. For example, the conductive pillar CPIL, the first pad PAD1, and the second pad PAD2 may each include at least one selected from copper, aluminum, tungsten, titanium, tantalum, iron, and any alloy thereof.

In some embodiments, the power management integrated circuit chip PMIC may be disposed within the redistribution substrate RSUB. For example, the power management integrated circuit chip PMIC may be provided within the base layer BASL. At least one of the conductive pillars CPIL may constitute an inductor (see L of FIG. 3) of a power management integrated circuit.

The connection bump CNBP may be disposed between the redistribution substrate RSUB and the connection substrate CSUB. The connection bump CNBP may be interposed between the first pad PAD1 and its corresponding lower bonding pad RDP3, thereby connecting the connection substrate CSUB to the redistribution substrate RSUB.

The conductive pillar CPIL may be electrically connected through the connection bump CNBP to the redistribution substrate RSUB. The connection bump CNBP may include at least one selected from a solder ball, a bump, and a pillar. The connection bump CNBP may include a metallic material.

A third under-fill layer UDFL3 may be interposed between the redistribution substrate RSUB and the connection substrate CSUB, thereby encapsulating the connection bump CNBP. The third under-fill layer UDFL3 may include a dielectric polymer.

The molding layer MOL may be provided on the connection substrate CSUB. The molding layer MOL may cover the first die DIE1 and the power management integrated circuit chip PMIC, while filling the substrate hole SHO. The molding layer MOL may be interposed between the first die DIE1 and the power management integrated circuit chip PMIC, between the power management integrated circuit chip PMIC and the connection substrate CSUB, and between the first die DIE1 and the connection substrate CSUB.

In an embodiment, an adhesive dielectric film may be attached to a top surface of the connection substrate CSUB, a sidewall of the power management integrated circuit chip PMIC, and a sidewall of the first die DIE1, with the result that the molding layer MOL may be formed. For example, an Ajinomoto build-up film (ABF) may be used as the adhesive dielectric film. For another example, the molding layer MOL may include a dielectric polymer, such as an epoxy-based polymer. For another example, the first and second under-fill layers UDFL1 and UDFL2 may be omitted, and the molding layer MOL may further extend onto a bottom surface of the power management integrated circuit chip PMIC and a bottom surface of the first die DIE1. When the third under-fill layer UDFL3 is omitted, the molding layer MOL may further extend into a gap between the redistribution substrate RSUB and the connection substrate CSUB.

The lower semiconductor package LPKG may further include an upper redistribution layer URL. The upper redistribution layer URL may be disposed on the molding layer MOL and the connection substrate CSUB. The upper redistribution layer URL may be identical or similar to the upper redistribution layer URL discussed above with reference to FIG. 16.

The upper semiconductor package UPKG may be provided on the lower semiconductor package LPKG. For example, the upper semiconductor package UPKG may be mounted on the upper redistribution layer URL. The upper semiconductor package UPKG may include an upper substrate USUB, a second die DIE2, and an upper molding layer UMOL. The upper semiconductor package UPKG and the first external terminal BP may be substantially the same as those discussed above with reference to FIG. 16. For example, the first external terminal BP may be interposed between the lower semiconductor package LPKG and the upper semiconductor package UPKG. The upper semiconductor package UPKG may further include a heat emission structure HES.

According to the claimed invention, a second impurity region is separated into segment regions, and according to claim 1 the separated segment regions are concentrated on a central region of a transistor set. Therefore, some embodiments may prevent burnt failure caused by drop in breakdown voltage of the transistor set and simultaneously may suppress a large reduction in specific on-resistance.

Although some example embodiments have been discussed with reference to accompanying figures, it will be understood that various changes in form and details may be made therein without departing from the scope of present disclosure. It therefore will be understood that the embodiments described above are just illustrative but not limitative in all aspects.

## Claims

1. A power management integrated circuit comprising a buck converter that includes a first metal oxide semiconductor field effect transistor, MOSFET, having a first conductivity type and a second MOSFET having a second conductivity type,
wherein the first MOSFET includes a plurality of transistor sets (TAS) that are two-dimensionally arranged,
wherein each of the plurality of transistor sets (TAS) includes a plurality of source regions (SR), a plurality of drain regions (DR), and a plurality of gate electrodes (GE) between the plurality of source regions (SR) and the plurality of drain regions (DR),
wherein each of the plurality of source regions (SR) and each of the plurality of drain regions (DR) includes an impurity region (NIR) having the first conductivity type,
wherein each of the plurality of source regions (SR) further includes a plurality of segment regions (ISR) having the second conductivity type (PIR),
wherein a first source region of the plurality of source regions is spaced apart from a second source region of the plurality of source regions in a first direction (D1),
wherein a first number of the plurality of segment regions in the first source region is different from a second number of the plurality of segment regions in the second source region, and wherein each of the plurality of transistor sets (TAS) includes a central region (CTR) and a peripheral region (PER) that surrounds the central region (CTR), and a first density of the plurality of segment regions in the central region is greater than a second density of the plurality of segment regions in the peripheral region.

2. A power management integrated circuit comprising a buck converter that includes a first metal oxide semiconductor field effect transistor, MOSFET, having a first conductivity type and a second MOSFET having a second conductivity type,
wherein the first MOSFET includes a plurality of transistor sets (TAS) that are two-dimensionally arranged,
wherein each of the plurality of transistor sets (TAS) includes a plurality of source regions (SR), a plurality of drain regions (DR), and a plurality of gate electrodes (GE) between the plurality of source regions (SR) and the plurality of drain regions (DR),
wherein each of the plurality of source regions (SR) and each of the plurality of drain regions (DR) includes an impurity region (NIR) having the first conductivity type,
wherein each of the plurality of source regions (SR) further includes a plurality of segment regions (ISR) having the second conductivity type (PIR),
wherein a first source region of the plurality of source regions is spaced apart from a second source region of the plurality of source regions in a first direction,
wherein a first number of the plurality of segment regions in the first source region is different from a second number of the plurality of segment regions in the second source region,
wherein each of the plurality of transistor sets further includes: a source electrode (SME) electrically connected in common to the plurality of source regions; and a drain electrode electrically (DME) connected in common to the plurality of drain regions, wherein a first density of the plurality of segment regions in a zone between the source electrode and the drain electrode is greater than a second density of the plurality of segment regions in a remaining zone other than the zone.

3. The power management integrated circuit of claim 1 or claim 2, wherein
the first number is greater than the second number, and
the first source region is closer than the second source region to a center of the transistor set which includes the first source region and the second source region.

4. The power management integrated circuit of any preceding claim, wherein:
each of the plurality of gate electrodes (GE) extends in a second direction that intersects the first direction, and
each of the plurality of segment regions are spaced apart from each other along the second direction (D2).

5. The power management integrated circuit of any preceding claim, wherein the plurality of segment regions include:
a first segment region in the first source region; and
a second segment region in the second source region,
wherein a size of the first segment region is different from a size of the second segment region.

6. The power management integrated circuit of any preceding claim, wherein each of the plurality of transistor sets further includes a guard ring region (GIR) that surrounds a boundary of the transistor set, the guard ring region having the second conductivity type.

7. The power management integrated circuit of any preceding claim, wherein:
each of the plurality of transistor sets further includes a silicide layer (SCL) on each of the plurality of source regions, and
the impurity region and the plurality of segment regions are connected at a same potential through the silicide layer.

8. The power management integrated circuit of any preceding claim, wherein:
each of the plurality of source regions further includes a lightly doped impurity region (LDR) below a corresponding gate electrode of the plurality of gate electrodes, the lightly doped impurity region having the first conductivity type,
when a transistor set is operated, a current flows from a drain region toward a corresponding source region, and
the current bypasses the plurality of segment regions of the corresponding source region and flows through the lightly doped impurity region toward the corresponding source region.

## Patentansprüche

1. Integrierte Leistungsmanagementschaltung, die einen Abwärtswandler, der einen ersten Metalloxid-Halbleiter-Feldeffekttransistor, MOSFET, beinhaltet, der einen ersten Leitfähigkeitstyp aufweist, und einen zweiten MOSFET, der einen zweiten Leitfähigkeitstyp aufweist, umfasst,
wobei der erste MOSFET eine Vielzahl von Transistorsätzen (TAS) beinhaltet, die zweidimensional eingerichtet sind,
wobei jeder der Vielzahl von Transistorsätzen (TAS) eine Vielzahl von Source-Bereichen (SR), eine Vielzahl von Drain-Bereichen (DR) und eine Vielzahl von Gate-Elektroden (GE) zwischen der Vielzahl von Source-Bereichen (SR) und der Vielzahl von Drain-Bereichen (DR) beinhaltet,
wobei jeder der Vielzahl von Source-Bereichen (SR) und jeder der Vielzahl von Drain-Bereichen (DR) einen Verunreinigungsbereich (NIR) beinhaltet, der den ersten Leitfähigkeitstyp aufweist,
wobei jeder der Vielzahl von Source-Bereichen (SR) weiter eine Vielzahl von Segmentbereichen (ISR) beinhaltet, die den zweiten Leitfähigkeitstyp (PIR) aufweist,
wobei ein erster Source-Bereich der Vielzahl von Source-Bereichen von einem zweiten Source-Bereich der Vielzahl von Source-Bereichen in einer ersten Richtung (D1) beabstandet ist,
wobei sich eine erste Anzahl der Vielzahl von Segmentbereichen in der ersten Source-Bereich von einer zweiten Anzahl der Vielzahl von Segmentbereichen in dem zweiten Source-Bereich unterscheidet, und wobei jeder der Transistorsätze (TAS) einen zentralen Bereich (CTR) und einen umfänglichen Bereich (CTR) beinhaltet, der den zentralen Bereich (PER) umgibt, und eine erste Dichte der Vielzahl von Segmentbereichen in dem zentralen Bereich größer ist als eine zweite Dichte der Vielzahl von Segmentbereichen in dem umfänglichen Bereich.

2. Integrierte Leistungsmanagementschaltung, die einen Abwärtswandler, der einen ersten Metalloxid-Halbleiter-Feldeffekttransistor, MOSFET, beinhaltet, der einen ersten Leitfähigkeitstyp aufweist, und einen zweiten MOSFET, der einen zweiten Leitfähigkeitstyp aufweist, umfasst,
wobei der erste MOSFET eine Vielzahl von Transistorsätzen (TAS) beinhaltet, die zweidimensional eingerichtet sind,
wobei jeder der Vielzahl von Transistorsätzen (TAS) eine Vielzahl von Source-Bereichen (SR), eine Vielzahl von Drain-Bereichen (DR) und eine Vielzahl von Gate-Elektroden (GE) zwischen der Vielzahl von Source-Bereichen (SR) und der Vielzahl von Drain-Bereichen (DR) beinhaltet,
wobei jeder der Vielzahl von Source-Bereichen (SR) und jeder der Vielzahl von Drain-Bereichen (DR) einen Verunreinigungsbereich (NIR) beinhaltet, der den ersten Leitfähigkeitstyp aufweist,
wobei jeder der Vielzahl von Source-Bereichen (SR) weiter eine Vielzahl von Segmentbereichen (ISR) beinhaltet, die den zweiten Leitfähigkeitstyp (PIR) aufweist,
wobei ein erster Source-Bereich der Vielzahl von Source-Bereichen von einem zweiten Source-Bereich der Vielzahl von Source-Bereichen in einer ersten Richtung beabstandet ist,
wobei sich eine erste Anzahl der Vielzahl von Segmentbereichen in dem ersten Source-Bereich von einer zweiten Anzahl der Segmentbereiche in der zweiten Source-Bereich unterscheidet,
wobei jeder der Vielzahl von Transistorsätzen weiter beinhaltet: eine Source-Elektrode (SME), die elektrisch mit der Vielzahl von Source-Bereichen gemeinsam verbunden ist; und eine Drain-Elektrode (DME), die elektrisch mit der Vielzahl von Drain-Bereichen gemeinsam verbunden ist, wobei eine erste Dichte der Vielzahl von Segmentbereichen in einer Zone zwischen der Source-Elektrode und der Drain-Elektrode größer ist als eine zweite Dichte der Vielzahl von Segmentbereichen in einer anderen verbleibenden Zone als die Zone.

3. Integrierte Leistungsmanagementschaltung nach Anspruch 1 oder Anspruch 2, wobei
die erste Anzahl größer ist als die zweite Anzahl, und
der erste Source-Bereich näher an einem Zentrum des Transistorsatzes, der den ersten Source-Bereich und dem zweiten Source-Bereich beinhaltet, liegt als der zweite Source-Bereich.

4. Integrierte Leistungsmanagementschaltung nach einem vorstehenden Anspruch, wobei:
sich jede der Vielzahl von Gate-Elektroden (GE) in einer zweiten Richtung, die die erste Richtung schneidet, erstreckt, und
jeder der Vielzahl von Segmentbereichen voneinander entlang der zweiten Richtung (D2) beabstandet ist.

5. Integrierte Leistungsmanagementschaltung nach einem vorstehenden Anspruch, wobei die Vielzahl von Segmentbereichen beinhaltet:
einen ersten Segmentbereich in dem ersten Source-Bereich; und
einen zweiten Segmentbereich in dem zweiten Source-Bereich,
wobei sich eine Größe des ersten Segmentbereichs von einer Größe des zweiten Segmentbereichs unterscheidet.

6. Integrierte Leistungsmanagementschaltung nach einem vorstehenden Anspruch, wobei jeder der Vielzahl von Transistorsätzen weiter einen Schutzringbereich (GIR) beinhaltet, der eine Grenze des Transistorsatzes umgibt, wobei der Schutzringbereich den zweiten Leitfähigkeitstyp aufweist.

7. Integrierte Leistungsmanagementschaltung nach einem vorstehenden Anspruch, wobei:
jeder der Vielzahl von Transistorsätzen weiter eine Silizidschicht (SCL) auf jedem der Vielzahl von Source-Bereichen beinhaltet, und
der Verunreinigungsbereich und die Vielzahl von Segmentbereichen durch die Silizidschicht mit demselben Potenzial verbunden sind.

8. Integrierte Leistungsmanagementschaltung nach einem vorstehenden Anspruch, wobei:
jeder der Vielzahl von Source-Bereichen weiter einen schwach dotierten Verunreinigungsbereich (LDR) unterhalb einer entsprechenden Gate-Elektrode der Vielzahl von Gate-Elektroden beinhaltet, wobei der schwach dotierte Verunreinigungsbereich den ersten Leitfähigkeitstyp aufweist,
wenn ein Transistorsatz betrieben wird, ein Strom von einem Drain-Bereich zu einem entsprechenden Source-Bereich fließt, und
der Strom die Vielzahl von Segmentbereichen des entsprechenden Source-Bereichs umgeht und durch den schwach dotierten Verunreinigungsbereich in Richtung des entsprechenden Source-Bereichs fließt.

## Revendications

1. Circuit intégré de gestion d'énergie comprenant un convertisseur abaisseur de tension qui inclut un premier transistor à effet de champ à semi-conducteur à oxyde métallique, MOSFET, présentant un premier type de conductivité et un second MOSFET présentant un second type de conductivité,
dans lequel le premier MOSFET inclut une pluralité d'ensembles de transistors (TAS) qui sont agencés en deux dimensions,
dans lequel chacun de la pluralité d'ensembles de transistors (TAS) inclut une pluralité de régions de source (SR), une pluralité de régions de drain (DR), et une pluralité d'électrodes de grille (GE) entre la pluralité de régions de source (SR) et la pluralité de régions de drain (DR),
dans lequel chacune de la pluralité de régions de source (SR) et chacune de la pluralité de régions de drain (DR) incluent une région d'impuretés (NIR) présentant le premier type de conductivité,
dans lequel chacune de la pluralité de régions de source (SR) inclut en outre une pluralité de régions de segment (ISR) présentant le second type de conductivité (PIR),
dans lequel une première région de source de la pluralité de régions de source est espacée d'une seconde région de source de la pluralité de régions de source dans une première direction (D1),
dans lequel un premier nombre de la pluralité de régions de segment dans la première région de source est différent d'un second nombre de la pluralité de régions de segment dans la seconde région de source, et dans lequel chacun de la pluralité d'ensembles de transistors (TAS) inclut une région centrale (CTR) et une région périphérique (PER) qui entoure la région centrale (CTR), et une première densité de la pluralité de régions de segment dans la région centrale est supérieure à une seconde densité de la pluralité de régions de segment dans la région périphérique.

2. Circuit intégré de gestion d'énergie comprenant un convertisseur abaisseur de tension qui inclut un premier transistor à effet de champ à semi-conducteur à oxyde métallique, MOSFET, présentant un premier type de conductivité et un second MOSFET présentant un second type de conductivité,
dans lequel le premier MOSFET inclut une pluralité d'ensembles de transistors (TAS) qui sont agencés en deux dimensions,
dans lequel chacun de la pluralité d'ensembles de transistors (TAS) inclut une pluralité de régions de source (SR), une pluralité de régions de drain (DR), et une pluralité d'électrodes de grille (GE) entre la pluralité de régions de source (SR) et la pluralité de régions de drain (DR),
dans lequel chacune de la pluralité de régions de source (SR) et chacune de la pluralité de régions de drain (DR) incluent une région d'impuretés (NIR) présentant le premier type de conductivité,
dans lequel chacune de la pluralité de régions de source (SR) inclut en outre une pluralité de régions de segment (ISR) présentant le second type de conductivité (PIR),
dans lequel une première région de source de la pluralité de régions de source est espacée d'une seconde région de source de la pluralité de régions de source dans une première direction,
dans lequel un premier nombre de la pluralité de régions de segment dans la première région de source est différent d'un second nombre de la pluralité de régions de segment dans la seconde région de source,
dans lequel chacun de la pluralité d'ensembles de transistors inclut en outre : une électrode de source (SME) connectée électriquement en commun à la pluralité de régions de source ; et une électrode de drain (DME) connectée électriquement en commun à la pluralité de régions de drain, dans lequel une première densité de la pluralité de régions de segment dans une zone entre l'électrode de source et l'électrode de drain est supérieure à une seconde densité de la pluralité de régions de segment dans une zone restante autre que la zone.

3. Circuit intégré de gestion d'énergie selon la revendication 1 ou la revendication 2, dans lequel
le premier nombre est supérieur au second nombre, et
la première région de source est plus proche que la seconde région de source d'un centre de l'ensemble de transistors qui inclut la première région de source et la seconde région de source.

4. Circuit intégré de gestion d'énergie selon une quelconque revendication précédente, dans lequel :
chacune de la pluralité d'électrodes de grille (GE) s'étend dans une seconde direction qui croise la première direction, et
chacune de la pluralité de régions de segment est espacée des autres le long de la seconde direction (D2).

5. Circuit intégré de gestion d'énergie selon une quelconque revendication précédente, dans lequel la pluralité de régions de segment inclut :
une première région de segment dans la première région de source ; et
une seconde région de segment dans la seconde région de source,
dans lequel une taille de la première région de segment est différente d'une taille de la seconde région de segment.

6. Circuit intégré de gestion d'énergie selon une quelconque revendication précédente, dans lequel chacun de la pluralité d'ensembles de transistors inclut en outre une région d'anneau de garde (GIR) qui entoure une limite de l'ensemble de transistors, la région d'anneau de garde présentant le second type de conductivité.

7. Circuit intégré de gestion d'énergie selon une quelconque revendication précédente, dans lequel :
chacun de la pluralité d'ensembles de transistors inclut en outre une couche de siliciure (SCL) sur chacune de la pluralité de régions de source, et
la région d'impuretés et la pluralité de régions de segment sont connectées à un même potentiel à travers la couche de siliciure.

8. Circuit intégré de gestion d'énergie selon une quelconque revendication précédente, dans lequel :
chacune de la pluralité de régions de source inclut en outre une région d'impuretés légèrement dopées (LDR) en dessous d'une électrode de grille correspondante de la pluralité d'électrodes de grille, la région d'impuretés légèrement dopées présentant le premier type de conductivité,
lorsqu'un ensemble de transistors fonctionne, un courant circule depuis une région de drain vers une région de source correspondante, et
le courant contourne la pluralité de régions de segment de la région de source correspondante et circule à travers la région d'impuretés légèrement dopées vers la région de source correspondante.
